# EUROPEAN PATENT APPLICATION

(11) **EP 2 725 594 A1**
(43) Date of publication of application: **30.04.2014**
(21) Application number: 11868840.7
(22) Date of filing: 27.06.2011
(51) Int. Cl.: H01G 2/08, H01G 4/224, H01G 9/00, H01G 9/08, H02M 7/48

(54) **CAPACITANCE ELEMENT HOUSING UNIT**

(71) Applicant: Toyota Jidosha Kabushiki Kaisha, Toyota-shi, Aichi 471-8571 (JP)
(72) Inventor: ISHIKAWA, Keitaro, Toyota-shi Aichi 471-8571 (JP)
(74) Representative: Winter, Brandl, Fürniss, Hübner, Röss, Kaiser, Polte - Partnerschaft
(86) International application number: PCT/JP2011/064707
(87) International publication number: WO 2013/001595

(57) **Abstract**

In order to provide a capacitance element housing unit with which the effect of suppressing heat transfer between capacitance elements can be increased more suitably, a capacitance element housing unit (10) is equipped with: a common package (104), which integrally houses a filter-use capacitance element (14) and a smoothing-use capacitance element (18), and which is provided with aslitpart (105) at the location between the filter-use capacitance element (14) and the smoothing-use capacitance element (18) where the temperature is high; a case (102) having cooling flow paths (108) for cooling a DC/DC converter (16) and an inverter (20); and an anchoring part (106) that anchors the common package (104) and the case (102) in the slit part (105).

## Description

### [TECHNICAL FIELD]

The present invention relates to a capacitance element housing unit.

### [BACKGROUND ART]

A hybrid vehicle is provided with a power converter which converts output electric power from a power storage device and supplies the converted electric power to a motor generator. The power converter is provided with a smoothing capacitance element which is connected to an input side of an inverter, and a filtering capacitance element which is connected to an input side of a DC-to-DC converter. It should be noted here that because the heatproof temperature of the smoothing capacitance element and that of the filtering capacitance element may be different, heat transfer between these capacitance elements should be suppressed when the smoothing capacitance element and the filtering capacitance element are enclosed in a single common package.

As a technique relating to the present invention, for example, Patent Document 1 discloses a power conversion unit which includes a DC-to-DC converter which receives DC power from a DC power supply and converts the received DC power to a different voltage level to output the DC power; an inverter which receives the DC power from the DC-to-DC converter and converts the received DC power to AC power to output the AC power; a first capacitance element provided on the input side of the DC-to-DC converter; and a second capacitance element provided on the input side of the inverter. It is disclosed that the first capacitance element and the second capacitance element are enclosed in a common package, and that, in order to suppress heat transfer between the first capacitance element and the second capacitance element, a slit is provided between the first capacitance element and the second capacitance element.

### [RELATED ART DOCUMENTS]

### [Patent Documents]

Patent Document 1: JP 2009-44920 A

### [DISCLOSURE OF THE INVENTION]

### [Problems to be Solved by the Invention]

Although it is possible to suppress heat transfer between the smoothing capacitance element and the filtering capacitance element according to Patent Document 1, it is necessary to provide a wide slit in order to enhance heat transfer suppression effect. However, a wide slit causes a risk of lowering the strength of the common package.

An obj ect of the present invention is to provide a capacitance element housing unit with which heat transfer suppression effect between capacitance elements can be enhanced more suitably.

### [Means for Solving the Problems]

A capacitance element housing unit according to the present invention comprises a common package which encloses a plurality of capacitance elements and includes a slit portion provided at a location between the plurality of capacitance elements where temperature becomes high; a case comprising a cooling portion which cools an element enclosed inside; and a fixing portion which fixes, in the slit portion, the common package to the case.

Further, it is preferable that, in a capacitance element housing unit according to the present invention, the fixing portion is provided at a location corresponding to a center between the capacitance elements which are adjacent to the slit portions.

Further, it is preferable that a capacitance element housing unit according to the present invention comprises a busbar connected to the plurality of capacitance elements; and the busbar is connected to the fixing portion.

Further, it is preferable that, in a capacitance element housing unit according to the present invention, the case encloses a first power conversion circuit and a second power conversion circuit, and the plurality of capacitance elements comprises: a first capacitance element connected to the first power conversion circuit; and a second capacitance element connected to the second power conversion circuit.

### [Effects of the Invention]

According to the above configuration, a slit portion is provided at a location between two or more capacitance elements where the temperature becomes high; and a common package is fixed, in the slit portion, to a case which includes a cooling portion. In this way, the heat from the two or more capacitance elements is allowed to transfer via the common package and the fixingportion. Therefore, it becomes possible to enhance heat transfer suppression effect more suitably.

### [BRIEF DESCRIPTION OF THE DRAWINGS]

FIG. 1 shows a configuration of a power conversion system including a capacitance element housing unit in an embodiment according to the present invention.
FIG. 2 shows a cross-sectional view of a capacitance element housing unit in an embodiment according to the present invention.
FIG. 3 shows a perspective diagram of a common package and a fixing portion in an embodiment according to the present invention.

### [BEST MODE FOR CARRYING OUT THE INVENTION]

In the description below, throughout the drawings, the same reference numerals are assigned to similar elements, and duplicate description is omitted. Further, in the description below, previously cited reference numerals are indicated where appropriate.

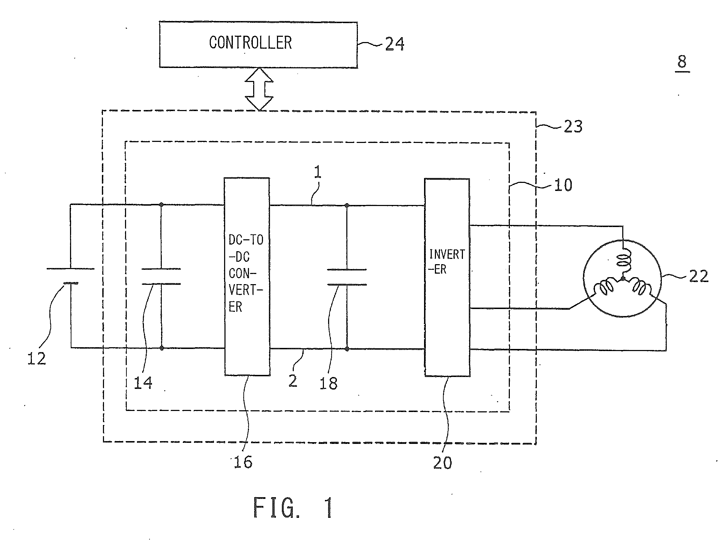

FIG. 1 shows a configuration of a power converter system 8 including a capacitance element housing unit 10. The power converter system 8 is provided with a power storage device 12, a motor generator 22, a power converter 23, and a controller 24. The power converter 23 is provided with a capacitance element housing unit 10, a filtering capacitance element 14, a DC-to-DC converter 16, a smoothing capacitance element 18, and an inverter 20. In the following description, the power converter system 8 is assumed to be mounted on a hybrid vehicle.

The power storage device 12 is a battery which supplies electric power to the motor generator 22. The power storage device 12 is also a chargeable and dischargeable DC power supply, which is, for example, a lithium ion secondary battery which includes a negative electrode made from a carbon material, electrolyte in which lithium ions can transfer, and a positive electrode active material in relation to which the lithium ions can be reversibly inserted into and removed from.

The filtering capacitance element 14 is provided on the input side of the DC-to-DC converter 16. The filtering capacitance element 14 is connected in parallel to the power storage device 12. The filtering capacitance element 14 has a function to suppress electric power fluctuation of the power storage device 12 which occurs during switching operation of a switching element included in the DC-to-DC converter 16.

The DC-to-DC converter 16 is a power converter circuit which boosts output electric power from the power storage device 12 and supplies the boosted electric power to the inverter 20 side. The DC-to-DC converter 16 also steps down the DC power supplied as regenerated power from the inverter 20 side and supplies the stepped down power to the power storage device 12 as charging electric power.

The smoothing capacitance element 18 is a capacitance element which is provided on the inverter 20 side. The smoothing capacitance element 18 has a function to suppress electric power fluctuation between a positive electrode bus 1 and a negative electrode bus 2. The positive electrode bus 1 is a power wire which connects terminals on the positive electrode sides of the DC-to-DC converter 16 and the inverter 20. The negative electrode bus 2 is a power wire which connects terminals on the negative electrode sides of the DC-to-DC converter 16 and the inverter 20. The heatproof temperature T₁ of the smoothing capacitance element 18 is different from the heatproof temperature T₂ of the filtering capacitance element 14. For example, the heatproof temperature T₂ of the filtering capacitance element 14 is higher than the heatproof temperature T₁ of the smoothing capacitance element 18.

The inverter 20 is a power converter circuit which converts DC power output from the DC-to-DC converter 16 to AC power and supplies the converted power to the motor generator 22 during power-applied running of a hybrid vehicle. The inverter 20 also converts AC power which is regenerated energy generated by the motor generator 22 and supplies the converted power to the DC-to-DC converter 16 during regenerating running of a hybrid vehicle.

The motor generator 22 is a three phase AC rotary electric machine (load circuit) which is configured to include a U-phase coil, a V-phase coil, and a W-phase coil. The motor generator 22 is connected with wheels of a hybrid vehicle via a power distribution mechanism (not shown).

The controller 24 has a function to control the whole power converter 23. The controller 24 includes, for example, switching control of a switching element of the inverter 20 and the DC-to-DC converter 16.

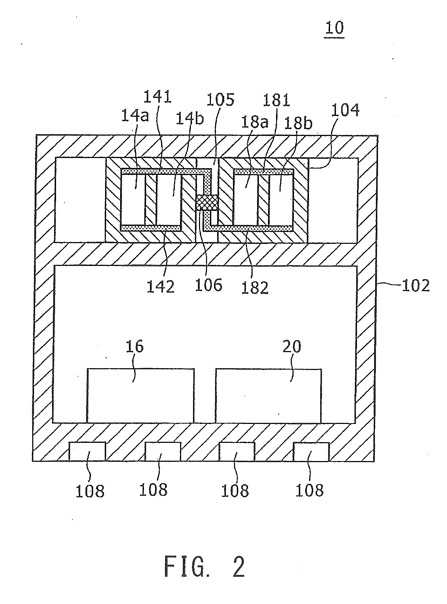

The capacitance element housing unit 10 is described next. FIG. 2 is a cross-sectional view of the capacitance element housing unit 10.

The capacitance element housing unit 10 is provided with a case 102, a common package 104, and a fixing portion 106. The case 102 internally encloses the common package 104 and the fixing portion 106. The common package 104 is fixed to an internal wall of the case 102 by the fixing portion 106.

The case 102 internally encloses the DC-to-DC converter 16 and the inverter 20. The case 102 is made from a conductive material such as metal having heat conductivity higher than that of the common package 104. The case 102 functions as a shield between the outside and the internally enclosed DC-to-DC converter 16 and the inverter 20. The case 102 has a cooling flow channel 108 through which coolant such as cooling liquid (cooling water) flows. The cooling flow channel 108 is a cooling portion which cools the case 102 by the cooling liquid which internally flows. This can achieve cooling of the DC-to-DC converter 16 and the inverter 20 enclosed inside the case 102.

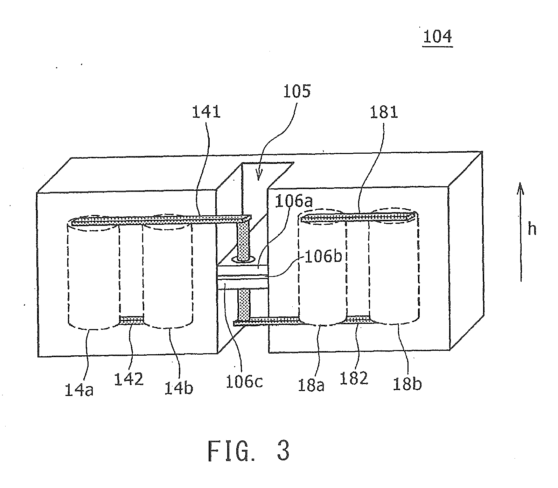

FIG. 3 is a perspective view of the common package 104 and the fixing portion 106. The common package 104 unitedly encloses and packages the filtering capacitance element 14 and the smoothing capacitance element 18. The filtering capacitance element 14 has two capacitance elements 14a, 14b. The smoothing capacitance element 18 includes two capacitance elements 18a, 18b. Although each of the filtering capacitance element 14 and the smoothing capacitance element 18 is assumed to have two capacitance elements in the description below, the number of the capacitance elements can be other than two.

As shown in FIG. 3, in the common package 104, the capacitance elements 14a, 14b and the capacitance elements 18a, 18b are enclosed to be spaced from each other. Each of the capacitance elements 14a, 14b and the capacitance elements 18a, 18b is sealed by a potting resin material surrounding these elements.

It should be noted that when the capacitance elements 14a, 14b and the capacitance elements 18a, 18b are enclosed in a single package, heat is easily transferred between these capacitance elements. In general, capacitance elements are required to sufficiently achieve performance within the heatproof temperature. However, in a case where the heatproof temperatures of the two or more capacitance elements are different, because heat is transferred from a capacitance element having a higher heatproof temperature to a capacitance element having a lower heatproof temperature, the capacitance element having the higher heatproof temperature should be used in accordance with the capacitance element having the lower heatproof temperature. In such a case, the performance of the capacitance element having the higher heatproof temperature cannot be sufficiently achieved.

Regarding this issue, in the common package 104, as shown in FIG. 3, a slit portion 105 is formed for suppressing the heat transfer between the capacitance element 14b and the capacitance element 18a which have different heatproof temperatures. The slit portion 105 is located between the capacitance element 14b and the capacitance element 18a which have different heatproof temperatures where the temperature becomes high in the common package 104. This slit portion 105 can suppress the heat transfer between the capacitance element 14b and the capacitance element 18a. Thus, because it becomes possible to thermally separate the capacitance element 14b having the higher heatproof temperature and the capacitance element 18a having the lower heatproof temperature, the heat transfer from the capacitance element 14b to the capacitance element 18a can be suppressed.

Further, the two filtering capacitance elements 14a, 14b forming the filtering capacitance element 14 are connected between the positive electrodes and between the negative electrodes respectively by a busbar 141 and a busbar 142. Specifically, the busbar 141 connects between the positive electrodes of the capacitance elements 14a, 14b, while the busbar 142 connects between the negative electrodes of the capacitance elements 14a, 14b. An end portion of the busbar 141 is further connected to a conductive portion 106a of the fixing portion 106.

Further, the two capacitance elements 18a, 18b forming the smoothing capacitance element 18 are connected between the positive electrodes and between the negative electrodes respectively by a busbar 181 and a busbar 182. Specifically, the busbar 181 connects between the positive electrodes of the capacitance elements 18a, 18b, while the busbar 182 connects between the negative electrodes of the capacitance elements 18a, 18b. An end portion of the busbar 182 is further connected to a conductive portion 106c of the fixing portion 106. The busbars 141, 142, 181, and 182 are made from a conductive material such as metal having high heat conductivity.

The fixing portion 106 is a fixing member located in the slit portion 105 to fix the common package 104 to an inner wall of the case 102 at the center in the height direction (arrow h) of the capacitance element 14b and the capacitance element 18a which are adjacent to the slit portion 105. The fixing portion 106 is provided with the conductive portions 106a, 106c which are conductively connected to the case 102, and an insulation portion 106b sandwiched between the conductive portions 106a, 106c to insulate between the conductive portions 106a, 106c. The conductive portions 106a, 106c are made from a conductive material such as metal having high heat conductivity.

Subsequently, advantages of the capacitance element housing unit 10 having the above structure are described below by referring to FIGs. 1 to 3.

In general, the heatproof temperature T₁ of the smoothing capacitance element 18 is different from the heatproof temperature T₂ of the filtering capacitance element 14. For example, the heatproof temperature T₂ of the filtering capacitance element 14 is higher than the heatproof temperature T₁ of the smoothing capacitance element 18. Thus, by forming the slit portion 105 with the common package 104, the transfer of heat from the filtering capacitance element 14 to the smoothing capacitance element 18 is suppressed. In order to achieve higher heat transfer suppression effect, it is necessary to broaden the slit width of the slit portion 105. However, if the slit width is broadened excessively, there is a risk of cracking in the common package 104 which could occur due to vibration or the like during running or other occasions of the hybrid vehicle. Therefore, it is necessary to enhance the heat suppression effect while suppressing cracking in the common package 104 due to vibration or the like during running of the hybrid vehicle or other occasions. This is an object to be achieved by the present invention.

According to the capacitance element housing unit 10 shown in FIGs. 1 to 3, it becomes possible to allow the heat of the capacitance element 14b of the filtering capacitance element 14 and the heat of the capacitance element 18a of the smoothing capacitance element 18 to transfer to the case 102 side via the fixing portion 106 having a high coefficient of heat conduction. It should be noted here that, as described above, because coolant flows in the cooling flow channel 108 of the case 102 in order to cool the DC-to-DC converter 16 and the inverter 20, the case 102 itself is also cooled. In this way, as the heat of the capacitance element 14b and the capacitance element 18a is allowed to transfer, these capacitance elements are cooled. Therefore, the heat transfer suppression effect between the capacitance element 14b and the capacitance element 18a can be enhanced. Further, because the fixing portion 106 is provided at the center portion where the temperature of the heat generated from the capacitance element 14b and the capacitance element 18a becomes the highest, the heat transfer can be suppressed more suitably.

Further, according to the capacitance element housing unit 10, an end portion of the busbar 141 which is connected to the positive electrodes of the two capacitance elements 14a, 14b forming the filtering capacitance element 14 is connected to the conductive portion 106a of the fixing portion 106. Because this allows the heat generated from the capacitance elements 14a, 14b to transfer to the case 102 side via the busbar 141 and the conductive portion 106a, the capacitance elements 14a, 14b themselves can be cooled. Similarly, an end portion of the busbar 182 which is connected to the negative electrodes of the two capacitance elements 18a, 18b forming the smoothing capacitance element 18 is connected to the conductive portion 106c of the fixing portion 106. Because this allows the heat generated from the capacitance elements 18a, 18b to transfer to the case 102 side via the busbar 182 and the conductive portion 106c, the capacitance elements 18a, 18b themselves can be cooled.

It should be noted that, although, in accordance with the above capacitance element housing unit 10, the busbar 141 and the busbar 182 are described as being connected to the fixing portion 106, the busbar 142 and the busbar 181 may be connected to each other. Alternatively, by increasing the number of insulation portions, all of the busbars may be connected to the case 102.

### [REFERENCE NUMERALS]

1 positive electrode bus, 2 negative electrode bus, 8 power converter system, 10 capacitance element housing unit, 12 power storage device, 14 filtering capacitance element, 14a, 14b capacitance elements, 16 converter, 18 smoothing capacitance element, 18a, 18b capacitance elements, 20 inverter, 22 motor generator, 23 power converter, 24 controller, 102 case, 104 common package, 105 slit portion, 106 fixing portion, 106a, 106c conductive portions, 106b insulation portion, 108 cooling flow channel, and 141, 142, 181, 182 busbars.

## Claims

1. A capacitance element housing unit comprising:
a common package which encloses a plurality of capacitance elements and includes a slit portion provided at a location between the plurality of capacitance elements where temperature becomes high;
a case comprising a cooling portion which cools an element enclosed inside; and
a fixing portion which fixes, in the slit portion, the common package to the case.

2. The capacitance element housing unit according to claim 1, wherein
the fixing portion is provided at a location corresponding to a center between the capacitance elements which are adjacent to the slit portions.

3. The capacitance element housing unit according to claim 1 or 2, wherein
the capacitance element housing unit further comprises a busbar connected to the plurality of capacitance elements; and
the busbar is connected to the fixing portion.

4. The capacitance element housing unit according to any one of claims 1 to 3, wherein
the case encloses a first power conversion circuit and a second power conversion circuit, and
the plurality of capacitance elements comprises:
a first capacitance element connected to the first power conversion circuit; and
a second capacitance element connected to the second power conversion circuit.
